# EUROPEAN PATENT SPECIFICATION

(11) **EP 1 593 167 B1**
(45) Date of publication and mention of the grant of the patent: **20.06.2007**
(21) Application number: 04709266.3
(22) Date of filing: 09.02.2004
(51) Int. Cl.: H01L 41/24

(54) **METHOD AND APPARATUS FOR MANUFACTURING CERAMIC DEVICES**
VERFAHREN UND VORRICHTUNG ZUR HERSTELLUNG KERAMISCHER BAUELEMENTE
PROCEDURE ET APPAREIL POUR LA FABRICATION DE DISPOSITIFS EN CERAMIQUE

(30) Priority: 12.02.2003 GB 0303150
(43) Date of publication of application: 09.11.2005
(73) Proprietor: 1...Limited, Cambridge, CB4 0WS (GB)
(72) Inventor: TOPLISS, Richard, Cambridge CB2 2NQ (GB); RICHARDS, David Charles William, Milton, Cambs CB4 6BL (GB)
(74) Representative: Merryweather, Colin Henry
(86) International application number: PCT/GB2004/000485
(87) International publication number: WO 2004/073077

(56) References cited:
- EP-A- 0 372 872
- WO-A-01/47041
- US-B1- 6 464 918

## Description

This invention relates to a method and apparatus for manufacturing curved elements of electro-active material. More particularly, it relates to a method and apparatus for manufacturing electro-active actuators curved around an axis which is itself curved.

Comparably large translation displacements have been recently achieved by using a curved, helical structure of coiled piezoelectric tape in which a multilayer tape is curved helically around an axis which is itself curved. Such devices are found to easily exhibit displacement in the order of millimetres on an active length of the order of centimetres. These structures and variations thereof are described, for example, in WO-01/47041 and in D. H. Pearce et al., Sensors and Actuators A 100 (2002), 281 -286.

These structures are ceramic devices of complex curved shape and are currently manufactured using inefficient low output methods which rely heavily on human labor. WO-01/47041, on which the two part form of claim 1 is based, describes a method of making the device comprising helically winding the tape around a first, cylindrical former which is made of a material able to deform plastically, and then winding the helically wound tape and the first former together around a second former. Other methods using extrusion processes are described for example in WO-02/103819. However the described process may not be feasible for all configurations of super-helical actuators.

Therefore it is seen as an object of the invention to provide a method and apparatus for manufacturing twice coiled actuators with limited human involvement and using flat ceramic tape as base material.

According to a first aspect of the invention, there is provided a method of manufacturing a ceramic device comprising: transporting ceramic tape in a green state into the proximity of a first forming element; fixing a first end of said tape with respect to said first forming element; and moving said tape and first forming element relatively to each other in a motion including simultaneous rotational and translational movements, thus winding said tape around said first forming element; characterized by further comprising: removing said fixing of said first end of said tape and separating said tape and first forming element to generate a helically wound pre-formed tape; fixing one end of said pre-formed tape with respect to a second forming element; and moving said pre-formed tape and second forming element relatively to each other in a motion including at least a rotational movement, thus winding said pre-formed tape around said second forming element.

According to a second aspect of the present invention, there is provided an apparatus for manufacturing a ceramic device from tape in a green state, the apparatus comprising a first forming element; a first clamping system for fixing one end of said tape with respect to said first forming element; a first mechanism, for moving said tape and first forming element relatively to each other in a motion including simultaneously rotational and translational movements, thus winding said tape around said first forming element to form a pre-formed tape, the first mechanism further being arranged to separate the pre-formed tape and the first forming element after release of the first clamping system; a second forming element; a second clamping system for fixing one end of said pre-formed tape with respect to said second forming element; and a second mechanism for moving said pre-formed tape and second forming element relatively to each other in a motion including at least a rotational movement, thus winding said pre-formed tape around said second forming element.

Preferably, during the movement of the tape and the first forming element relatively to each other the tape is continuously pressed onto the first forming element at a zone where the tape comes into contact with the first forming element as the tape is wound around the first forming element.

Preferably, during the movement of the tape and the first forming element relating to each other, a force is exerted on the edge of the tape at a zone where the tape come into contact with the first forming element as the tape is wound around the first forming element to prevent slippage of the tape relative to the first forming element.

Preferably, the clamping systems or elements used for gripping the tape or other devices designed to exert pressure directly onto the tape are pneumatically operated or spring-loaded to simulate a "tactile" handling of the tape.

Preferably, during the movement said pre-formed tape and second forming element relatively to each other, the pre-formed tape is held at both ends using clamping elements, one of said clamping elements fixing one end of said pre-formed tape with respect to the second forming element, the other clamping element performing a relative rotational movement around said second forming element.

The method preferably includes the steps of and devices for removing the fixing with respect to the second forming element and transferring the wound pre-formed tape onto a support structure; and placing the support structure into heated environment for drying and/or sintering.

These and other aspects of inventions will be apparent from the following detailed description of non-limitative examples making reference to the following drawings.

In the drawings:
FIG. 1 is a perspective view of a twice-coiled actuator as known;
FIG. 2 illustrates a first forming step in accordance with an example of the present invention;
FIG. 3A illustrates a step of releasing pre-formed tape from a first forming element;
FIG. 3B illustrates a second forming step in accordance with an example of the present invention; and
FIG. 4 illustrates the transfer of formed tape onto a support structure for drying.

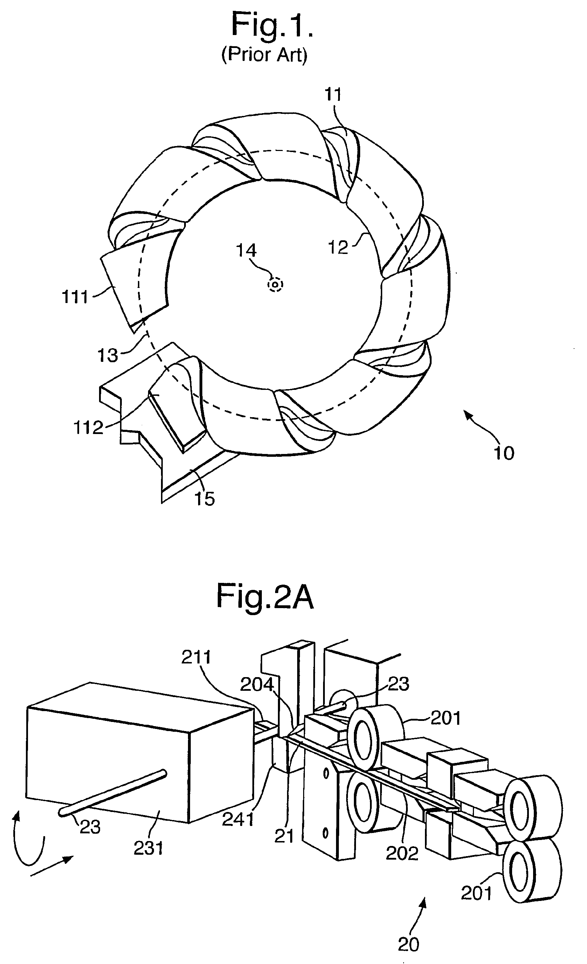

FIG. 1 shows a known actuator 10 of the type described in WO-01/47041 and Sensors and Actuators A 100 (2002), 281 -286.

The actuator 10 has a curved portion 12 of multi-layer tape 11, for example of a bimorph construction, that is wound helically around a first axis 13 referred to as the minor axis. For illustration, the minor axis is shown as a dashed line 13 in FIG. 1. The helically wound portion is further coiled into a secondary winding of about three quarters of a complete turn. The axis 14 of this secondary winding is referred to as the major axis and shown as a small dashed circle 14 with a central solid point again to facilitate description and illustration. The first winding is known as the primary winding or primary helix. The secondary winding could be any curve and could exceed one turn and form a spiral or secondary helix. It is therefore usually referred to as secondary curve. The tape is arranged on actuation to bend around the minor axis 13. Due to the helical curve around the minor axis, such bending is concomitant with twisting of the actuator 10 around the minor axis. Due to the curve around the major axis 14, such twisting is concomitant with relative displacement of the ends 111, 112 of the actuator 10. When used as an actuator, one end 111 of the tape 11 may be fixed to a moveable object (not shown) while the other end 112 of the tape 11 may be mounted onto a base plate 15.

The manufacture of the actuator 10 from a precursor ceramic tape is a very complex task usually performed by manual labor. It involves the steps of slowly winding a helix of the tape around a cylindrical rod and, and after carefully removing the rod, placing the helix into a "sagger" that supports the helix in its coiled form during subsequent drying until the ceramic tape is sufficiently stiff to support its own weight. The coiled helix is then burned to remove binder and other organic components and sintered to form the ceramic actuator.

While the above steps can be performed manually, the process does not readily lend itself for automation. The properties of the precursor ceramic tape are such that, though pliable, it slackens readily and is unable to support its own weight.

Referring now to FIG. 2A, there is shown a conveyor system 20 that transports a strip of precursor ceramic tape 21 to a cylindrical rod 23. The conveyor system 20 includes rollers 201 and support surfaces 202 that guide the strip 21 close to the former 23. A smoothly contoured surface 204 directs the tape 21 under the rod 23. When positioned at the conveyor system 20, an end block 231 supports the distal end of the rod to prevent it from bending and provides a rotary drive for rotating the rod 23 and a linear drive for translating the rod 23. After a stub 211 of tape 21 of sufficient length has passed a first pneumatically operated clamp 241 closes and fixes the tape 21 against the rod 23. Then the rod 23 is rotated and translated as indicated, while more tape is pushed through the conveyor system 20. Thus the end block 231 and the conveyor system 20 act as the a first mechanism for moving the tape 21 and the rod 23 relatively to each other.

The rod 23 acts as a primary or first former. Its diameter is chosen such that it matches the inner diameter of the primary helix.

The conveyor and the axis of the rod form an acute angle to feed tape at this angle onto the rod. As the strip is pushed by the conveyor across the rod 23, the rotation of the rod 23 causes the strip 21 to be wound around it. Simultaneously with the rotation, the rod 23 is moved in direction of its axis. Both motions are synchronized such that the tape is wound around the rod in a helical manner.

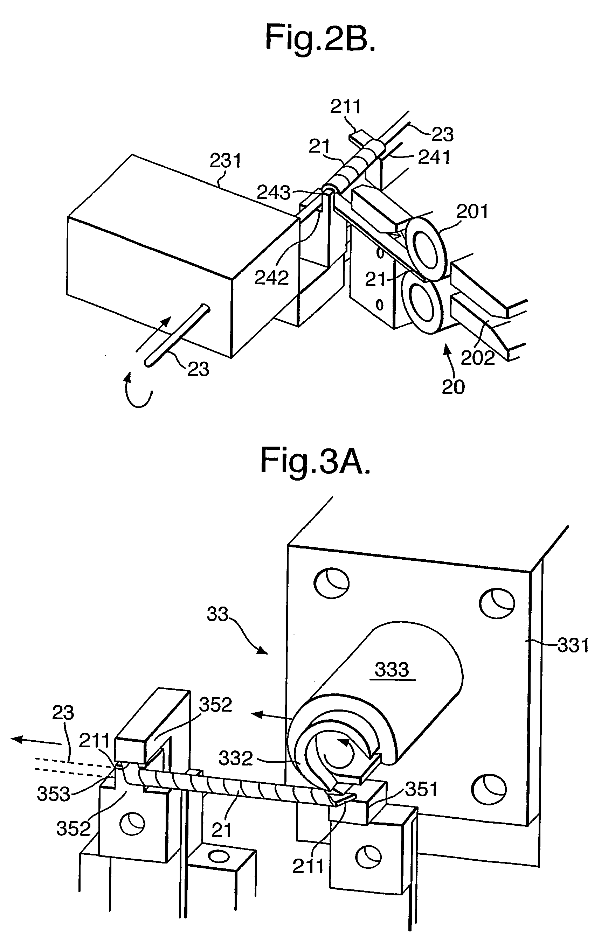

In FIG. 2B, the winding process of FIG. 2A is shown at a later stage with the tape 21 being wound around the former 23 for approximately half of its length. As the first clamp 241 is retracted from the conveyor system 20, a second spring-loaded clamp 242 is brought from below into contact with the tape 21. The second clamp 242 has a slightly concave surface with a stop pin 243. The concave surface maintains pressure on the tape while the stop pin 243 prevents the slippage of tape along the rotating rod 23, thus ensuring that the helix remains tightly wound.

After the strip of tape 21 is fully wound around the primary former 23, the second end of the tape forms a second short stub (not shown) similar to the stub 211. The rod 23 is then moved by the linear drive of the block 231 to a second forming element 33. During the transport both clamps 241, 242 remain in place.

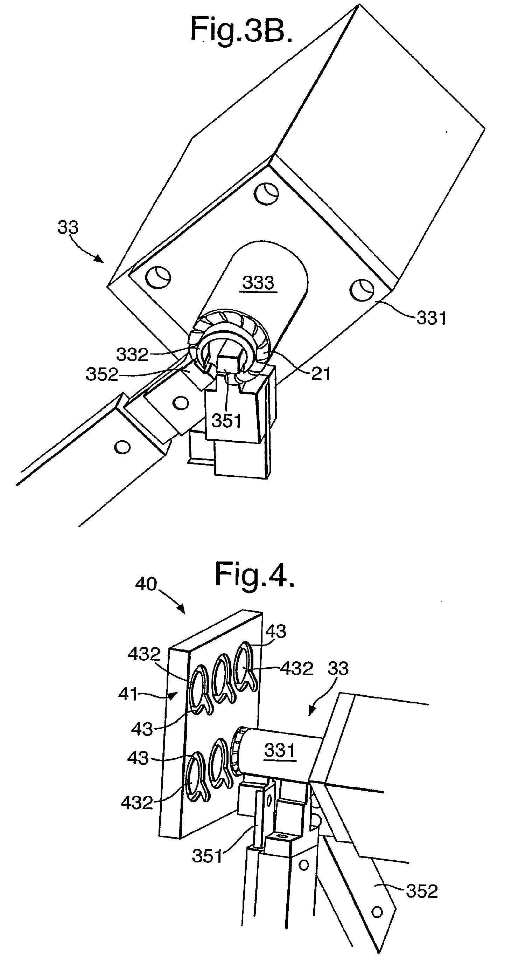

At the location of the second former 33, two clamps 351, 352 grip the tape at the stubs 211 as illustrated in FIG. 3A. The previous clamps 241, 242 are released and the forming rod 23 is moved in axial direction in sliding contact with an edge 353. The first former 23 is shown as a dashed outline. The first clamp 351 is fixed to the mounting block 331 that carries the second former 33. It pushes the stub 211 at one end of the tape 21 against the outer edge of the inner cylinder 332 of the second former 33. The combined clamp 351 and second former 33 are simultaneously rotated around the center axis of the cylindrical second former 33 and moved towards the second clamp 352 that rests immobile during this movement. Thus, the first clamp 351 and the second clamp 352 form a second mechanism for moving said pre-formed tape and second forming element relatively to each other. As the second former 33 approaches the second clamp, more of the rod 23 slides over an edge 353 and more windings are pushed from the distal end of the rod. The windings are wound around the inner cylinder 332 of the rotating secondary former 33 until the tape is completely stripped of the primary former. At this stage, which is illustrated in FIG. 3B, the pre-formed tape 21 is wound completely around the inner cylinder 332 of second former 33 and held in place by the two clamps 351, 352.

The inner cylinder 332 is spring-mounted within a bore of an outer cylinder 333 of the second former 33, such that pressure on the front face of the inner cylinder causes it to retract into the bore while the advancing sleeve of the outer cylinder pushes the wound tape 21 from the former.

At this stage of the process the twice-coiled actuator of FIG. 1 is completed in its "green" state. However to stabilize the structure, the tape 21 has to be at least dried. To free the second former 33, the wound helix is transferred into a tray or array for further handling off-line.

In FIG. 4, the secondary former 33 is shown approaching a array 40 of saggers 41. As the secondary former meets a sagger 41, the front face of its inner cylinder 332 (shown in FIG. 3 above) engages a matching cylinder 431 within a recess area 432 of a sagger 41. As the secondary former moves closer to a sagger, the spring-loaded inner cylinder 332 remains stationary and the outer ring 333 pushes the twice-coiled helix into the recess 432 of the sagger. The clamps that grip the stubs or ends of the tape open to release the helix. The outer boundary of the recess area 432 has a diameter that closely matches the nominal outer diameter of the major helix of the actuator. The edges of the boundary of the recess area are contoured or chamfered to assist the placing of the tape into the sagger. The sagger array 40 filled with fully formed green tape is then placed in a heated environment for drying and prepared for further processing stages such as sintering in an oven.

The various clamping devices described above are using pneumatically operated actuators commercially available for example from Festo. Commercially available DC servo motors are used to generate other movements of the components. All components are under the control of a computer program stored in and executed from an Intel processor based workstation.

Variations of the above example are readily within the scope of a skilled person. It is for example feasible to design the forming elements in a segmented manner to alter their diameter and hence the dimensions of the actuator. It is also possible to replace the second forming element with a removable sagger and thus wind the pre-formed tape directly onto the sagger.

## Claims

1. A method of manufacturing a ceramic device comprising:
transporting ceramic tape (21) in a green state into the proximity of a first forming element (23);
fixing a first end (211) of said tape (21)with respect to said first forming element (23); and
moving said tape (21) and first forming element (23) relatively to each other in a motion including simultaneous rotational and translational movements, thus winding said tape (21) around said first forming element (23);
**characterized by** further comprising:
removing said fixing of said first end (211) of said tape (21) and separating said tape (21) and first forming element (23) to generate a helically wound pre-formed tape (21);
fixing one end of said pre-formed tape (21) with respect to a second forming element (33); and
moving said pre-formed tape (21) and second forming element (33) relatively to each other in a motion including at least a rotational movement, thus winding said pre-formed tape (21) around said second forming element (33).

2. The method of claim 1, further comprising, during the step of moving said tape (21) and first forming element (23) relatively to each other, continuously pressing said tape (21) onto said first forming element (23) at a zone where said tape (21) comes into contact with said first forming element (23) as the tape (21) is wound around the first forming element (23).

3. The method of claim 2, further comprising, during the step of moving said tape (21) and first forming element (23) relatively to each other, exerting a force on the edge of the tape (21) at a zone where said tape (21) comes into contact with the first forming element (23) as the tape (21) is wound around the first forming element (23) to prevent slippage of said tape (21) relative to said first forming element (23).

4. The method of any one of the preceding claims, further comprising, between the step of moving said tape (21)and first forming element (23)relatively to each other and the step of removing said fixing of said first end (211) of said tape (21), closing a clamping element (351) around the first end (211) of the tape (21).

5. The method of any one of the preceding claims, wherein the step of separating said tape (21) and first forming element (23) comprises moving the first forming element (23) relatively to an edge (353) holding back the pre-formed tape (21).

6. The method of any one of the preceding claims, wherein, during the step of moving said pre-formed tape (21) and second forming element (33) relatively to each other, the pre-formed tape (21) is held at both ends (211) using clamping elements (351, 352), one of said clamping elements (351) fixing one end of said pre-formed tape (21) with respect to the second forming element (35), the other clamping element (352) performing a relative rotational movement around said second forming element (33).

7. The method of any one of the preceding claims, further comprising the steps of
removing the fixing with respect to the second forming element (33) and transferring the wound pre-formed tape onto a support structure (41); and
placing said support structure (41) into environment for drying and/or sintering.

8. The method of any one of the preceding claims, wherein the tape (21) is handled by pneumatically operated devices.

9. The method of any one of the preceding claims, wherein the step of moving said tape (21) and first forming element (23) relatively to each other comprises rotating the first forming element (23) and translating the unwound portion of the tape (21) towards the first forming element 23.

10. The method of claim 9, wherein the step of moving said tape (21) and first forming element (23) relatively to each other further comprises translating the first forming element (23) along an axis about which the tape (21) is wound.

11. The method of any one of the preceding claims, wherein the first forming element (23) is cylindrical.

12. The method of any one of the preceding claims, wherein the tape (21) comprises layers of electro-active material.

13. An apparatus for manufacturing a ceramic device from tape in a green state, the apparatus comprising
a first forming element (23);
a first clamping system (241) for fixing one end (211) of said tape (21) with respect to said first forming element (23);
a first mechanism (20, 231) for moving said tape (21) and first forming element (23) relatively to each other in a motion including simultaneously rotational and translational movements, thus winding said tape (21) around said first forming element to form a pre-formed tape (21), the first mechanism further being arranged to separate the pre-formed tape (21) and the first forming element (23) after release of the first clamping system (24);
a second forming element (33);
a second clamping system (351) for fixing one end (211) of said pre-formed tape (21) with respect to said second forming element (33); and
a second mechanism (351, 352) for moving said pre-formed tape (21) and second forming element (33) relatively to each other in a motion including at least a rotational movement, thus winding said pre-formed tape around said second forming element (33).

14. The apparatus of claim 13, wherein the first clamping system (241) includes a spring-loaded surface (242) that in operation continuously presses the tape (21) onto said first forming element (23) at a zone where said tape (21) comes into contact with said first forming element (23) as the tape (21) is wound around the first forming element (23).

15. The apparatus of claim 14, wherein the spring-loaded surface is combined with a force-transmitting member (243) adapted to contact the edge of the tape (21) at a zone where said tape (21) comes into contact with the first forming element as the tape (21) is wound around the first forming element (23) to prevent slippage of said tape (21) relative to said first forming element (23).

16. The apparatus of any one of claims 13 to 15, further comprising a stripping edge (353) making contact to the first forming element (23) to separate said first forming element (23) and the pre-formed tape (21).

17. The apparatus of any one of claims 13 to 16, wherein the second mechanism includes a third clamping system (352) for clamping the other end of the tape (21), the second mechanism being arranged to relatively rotate the third clamping system (352) around said second forming element (33).

18. The apparatus of claim 17, further comprising one or more saggers (41) having recesses (432) adapted to support the formed tape (21) during drying.

19. The apparatus of any one of claims 13 to 18, wherein the clamping systems (241, 351) are pneumatically operated.

20. The apparatus of any one of claims 13 to 19, wherein the first forming element (23) is a cylindrical rod.

21. The apparatus of any one of claims 13 to 20, wherein the first mechanism comprises a rotary drive (231)arranged to rotate the first forming member (23) and a conveyor system (20) arranged to translate the tape (21) towards the first forming member (23).

22. The apparatus of claim 21, wherein the first mechanism further comprises a linear drive (231) arranged to translate the first forming member (23) along an axis about which the tape (21) is wound.

## Patentansprüche

1. Verfahren zum Herstellen einer keramischen Einrichtung, aufweisend
Transportieren eines keramischen Bands (21) in einem Rohzustand in die Nähe eines ersten formenden Elements (23),
Fixieren eines ersten Endes (211) des Bands (21) bezüglich des ersten formenden Elements (23), und
Bewegen des Bands (21) und des ersten formenden Elements (23) relativ zueinander in einer Bewegung, die gleichzeitige Rotations- und Translationsbewegungen enthält, und somit Wickeln des Bands (21) um das erste formende Element (23),
**gekennzeichnet durch** weiter Aufweisen von
Lösen der Fixierung des ersten Endes (211) des Bands (21) und Trennen des Bands (21) und des ersten formenden Elements (23) zum Erzeugen eines spiralförmig gewickelten vorgeformten Bands (21),
Fixieren eines Endes des vorgeformten Bands (21) bezüglich eines zweiten formenden Elements (33), und
Bewegen des vorgeformten Bands (21) und des zweiten formenden Elements (33) relativ zueinander in einer Bewegung, die zumindest eine Rotationsbewegung enthält, und somit Wickeln des vorgeformten Bands (21) um das zweite formende Element (33).

2. Verfahren nach Anspruch 1, weiter aufweisend, während des Schritts des Bewegens des Bands (21) und des ersten formenden Elements (23) relativ zueinander, kontinuierliches Drücken des Bands (21) auf das erste formende Element (21) in einem Gebiet, in dem das Band (21) in Berührung mit dem ersten formenden Element (23) kommt, während das Band (21) um das erste formende Element (23) gewickelt wird.

3. Verfahren nach Anspruch 2, weiter aufweisend, während des Schritts des Bewegens des Bands (21) und des ersten formenden Elements (23) relativ zueinander, Ausüben einer Kraft an dem Rand des Bands (21) in einem Gebiet, in dem das Band (21) in Berührung mit dem ersten formenden Element (23) kommt, während das Band (21) um das erste formende Element (23) gewickelt wird, um ein Rutschen des Bands (21) relativ zu dem ersten formenden Element (23) zu verhindern.

4. Verfahren nach einem der vorhergehenden Ansprüche, weiter aufweisend, zwischen dem Schritt des Bewegens des Bands (21) und des ersten formenden Elements (23) relativ zueinander und dem Schritt des Lösens der Fixierung des ersten Endes (211) des Bands (21), Schließen eines Halteelements (351) um das erste Ende (211) des Bands (21).

5. Verfahren nach einem der vorhergehenden Ansprüche, bei dem der Schritt des Trennens des Bands (21) und des ersten formenden Elements (23) ein Bewegen des ersten formenden Elements (23) relativ zu einem Rand (353), der das vorgeformte Band (21) zurückhält, aufweist.

6. Verfahren nach einem der vorhergehenden Ansprüche, bei dem, während des Schritts des Bewegens des vorgeformten Bands (21) und des zweiten formenden Elements (33) relativ zueinander, das vorgeformte Band (21) an beiden Enden (211) durch Verwenden von Halteelementen (351, 352) gehalten wird, wobei eines der Halteelemente (351) ein Ende des vorgeformten Bands (21) bezüglich des zweiten formenden Element (35) fixiert, das andere Halteelement (352) eine relative Rotationsbewegung um das zweite formende Element (33) ausführt.

7. Verfahren nach einem der vorhergehenden Ansprüche, weiter aufweisend die Schritte Lösen der Fixierung bezüglich des zweiten formenden Elements (33) und Übertragen des gewickelten vorgeformten Bands an eine Stützstruktur (41), und
Platzieren der Stützstruktur (41) in eine Umgebung zum Trocknen und/oder Sintern.

8. Verfahren nach einem der vorhergehenden Ansprüche, bei dem das Band (21) durch pneumatisch betriebene Einrichtungen behandelt und/oder befördert wird.

9. Verfahren nach einem der vorhergehenden Ansprüche, bei dem der Schritt des Bewegens des Bands (21) und des ersten formenden Elements (23) relativ zueinander ein Drehen des ersten formenden Elements (23) und translatorisches Verschieben des ungewickelten Abschnitts des Bands (21) in Richtung zu dem ersten formenden Element (23) aufweist.

10. Verfahren nach Anspruch 9, bei dem der Schritt des Bewegens des Bands (21) und des ersten formenden Elements (23) relativ zueinander ein translatorisches Verschieben des ersten formenden Elements (23) entlang einer Achse, um die das Band (21) gewickelt wird, aufweist.

11. Verfahren nach einem der vorhergehenden Ansprüche, bei dem das erste formende Element (23) zylindrisch ist.

12. Verfahren nach einem der vorhergehenden Ansprüche, bei dem das Band (21) Schichten aus elektroaktivem Material aufweist.

13. Vorrichtung zum Herstellen einer keramischen Einrichtung aus einem Band in einem Rohzustand, welche Vorrichtung aufweist
ein erstes formendes Element (23),
ein erstes Haltesystem (241) zum Fixieren eines Endes (211) des Bands (21) bezüglich des ersten formenden Elements (23),
einen ersten Mechanismus (20, 231) zum Bewegen des Bands (21) und des ersten formenden Elements (23) relativ zueinander in einer Bewegung, die gleichzeitige Rotations- und Translationsbewegungen enthält, und somit Wickeln des Bands (21) um das erste formende Element zum Formen eines vorgeformten Bands (21), wobei der erste Mechanismus weiter angeordnet ist zum Trennen des vorgeformten Bands (21) und des ersten formenden Elements (23) nach einem Lösen des ersten Haltesystems (24),
ein zweites formendes Element (33),
ein zweites Haltesystem (351) zum Fixieren eines Endes (211) des vorgeformten Bands (21) bezüglich des zweiten formenden Elements (33), und
einen zweiten Mechanismus (351, 352) zum Bewegen des vorgeformten Bands (21) und des zweiten formenden Elements (33) relativ zueinander in einer Bewegung, die wenigestens eine Rotationsbewegung enthält, und somit Wickeln des vorgeformten Bands um das zweite formende Element (33).

14. Vorrichtung nach Anspruch 13, bei der das erste Haltesystem (241) eine federbelastete Fläche (242) aufweist, die im Betrieb kontinuierlich das Band (21) auf das erste formende Element (23) in einem Gebiet, in dem das Band (21) in Berührung mit dem ersten formenden Element (23) kommt, drückt, während das Band (21) um das erste formende Element (23) gewickelt wird.

15. Vorrichtung nach Anspruch 14, bei der die federbelastete Fläche mit einem kraftübertragenden Bauteil (243) verbunden ist, das geeignet ist, den Rand des Bands (21) in einem Gebiet zu berühren, in dem das Band (21) in Berührung mit dem ersten formenden Element kommt, während das Band (21) um das erste formende Element (23) gewickelt wird, um ein Rutschen des Bands (21) relativ zu dem formenden Element (23) zu verhindern.

16. Vorrichtung nach einem der Ansprüche 13 bis 15, die weiter eine abstreifende Kante (353) aufweist, die einen Berührung zu dem ersten formenden Element (23) zum Trennen des ersten formenden Elements (23) und des vorgeformten Bands (21) herstellt.

17. Vorrichtung nach einem der Ansprüche 13 bis 16, bei der der zweite Mechanismus ein drittes Haltesystem (352) zum Halten des anderen Endes des Bands (21) aufweist, wobei der zweite Mechanismus zum Drehen des dritten Haltesystems (352) relativ um das zweite formende Element (33) angeordnet ist.

18. Vorrichtung nach Anspruch 17, die weiter eine oder mehrere Brennkapseln (41) aufweist, die Ausnehmungen (432) aufweisen, die geeignet sind zum Tragen des Bands (21) während eines Trocknens.

19. Vorrichtung nach einem der Ansprüche 13 bis 18, bei der die Haltesysteme (241, 351) pneumatisch betrieben sind.

20. Vorrichtung nach einem der Ansprüche 13 bis 19, bei der das erste formende Element (23) ein zylindrischer Stab ist.

21. Vorrichtung nach einem der Ansprüche 13 bis 20, bei der der erste Mechanismus einen Drehantrieb (231), der angeordnet ist zum Drehen des ersten formenden Elements (23), und ein Fördersystem (20), das angeordnet ist zum translatorischen Verschieben des Bands (21) in Richtung zu dem ersten formenden Element (23), aufweist.

22. Vorrichtung nach Anspruch 21, bei der der erste Mechanismus weiter einen Linearantrieb (231) aufweist, der angeordnet ist zum translatorischen Verschieben des ersten formenden Elements (23) entlang einer Achse, um die das Band (21) gewunden wird.

## Revendications

1. Procédé de fabrication d'un dispositif en céramique comprenant les opérations consistant à :
transporter un ruban de céramique (21) dans un état cru à proximité d'un premier élément de façonnage (23) ;
fixer une première extrémité (211) dudit ruban (21) par rapport audit premier élément de façonnage (23) ; et
déplacer ledit ruban (21) et le premier élément de façonnage (23) l'un par rapport à l'autre dans un mouvement comprenant des mouvements de rotation et de translation simultanés, pour enrouler de ce fait ledit ruban (21) autour dudit premier élément de façonnage (23) ;
**caractérisé en ce qu'**il comprend en outre les opérations consistant à :
retirer ladite fixation de ladite première extrémité (211) du ruban (21) puis séparer ledit ruban (21) dudit premier élément de façonnage (23) pour générer un ruban préformé enroulé de façon hélicoïdale (21);
fixer une extrémité dudit ruban préformé (21) par rapport à un deuxième élément de façonnage (33) ; et
déplacer ledit ruban préformé (21) et ledit deuxième élément de façonnage (33) l'un par rapport à l'autre dans un mouvement comprenant au moins un mouvement de rotation, pour enrouler de ce fait ledit ruban préformé (21) autour dudit deuxième élément de façonnage (33).

2. Procédé selon la revendication 1, comprenant en outre, pendant l'étape de déplacement dudit ruban (21) et du premier élément de façonnage (23) l'un par rapport à l'autre, le fait de presser en continu ledit ruban (21) sur ledit premier élément de façonnage (23) dans une zone où ledit ruban (21) vient en contact avec ledit premier élément de façonnage (23) pendant que le ruban (21) s'enroule autour du premier élément de façonnage (23).

3. Procédé selon la revendication 2, comprenant en outre, pendant l'étape de déplacement dudit ruban (21) et du premier élément de façonnage (23) l'un par rapport à l'autre, le fait d'exercer un effort sur le bord du ruban (21) dans une zone où ledit ruban (21) vient en contact avec ledit premier élément de façonnage (23) pendant que le ruban (21) s'enroule autour du premier élément de façonnage (23) pour empêcher le glissement dudit ruban (21) par rapport audit premier élément de façonnage (23).

4. Procédé selon l'une quelconque des revendications précédentes, comprenant en outre, entre l'étape de déplacement dudit ruban (21) et du premier élément de façonnage (23) l'un par rapport à l'autre et l'étape de suppression de ladite fixation de la première extrémité (211) dudit ruban (21), le fait de fermer un élément de serrage (351) autour de la première extrémité (211) du ruban (21).

5. Procédé selon l'une quelconque des revendications précédentes, dans lequel l'étape de séparation du ruban (21) dudit premier élément de façonnage (23) comprend le fait de déplacer le premier élément de façonnage (23) par rapport à un bord (353) qui retient le ruban préformé (21).

6. Procédé selon l'une quelconque des revendications précédentes, dans lequel, pendant l'étape de déplacement dudit ruban préformé (21) et du deuxième élément de façonnage (33) l'un par rapport à l'autre, le ruban préformé (21) est maintenu aux deux extrémités (211) à l'aide d'éléments de serrage (351, 352), l'un desdits éléments de serrage (351) fixant une extrémité dudit ruban préformé (21) par rapport au deuxième élément de façonnage (33), l'autre élément de serrage (352) effectuant un mouvement de rotation relatif autour dudit deuxième élément de façonnage (33).

7. Procédé selon l'une quelconque des revendications précédentes, comprenant en outre les étapes consistant à :
supprimer la fixation par rapport au deuxième élément de façonnage (33) et transférer le ruban préformé enroulé sur une structure de support (41) ; et
placer ladite structure de support (41) dans un environnement de séchage et/ou de frittage.

8. Procédé selon l'une quelconque des revendications précédentes, dans lequel le ruban est manipulé par des dispositifs actionnés de façon pneumatique.

9. Procédé selon l'une quelconque des revendications précédentes, dans lequel l'étape de déplacement dudit ruban (21) et du premier élément de façonnage (23) l'un par rapport à l'autre comprend le fait de faire tourner le premier élément de façonnage (23) et de faire translater la partie non enroulée du ruban (21) vers le premier élément de façonnage (23).

10. Procédé selon la revendication 9, dans lequel l'étape de déplacement dudit ruban (21) et du premier élément de façonnage (23) l'un par rapport à l'autre comprend en outre le fait de faire translater le premier élément de façonnage (23) le long d'un axe autour duquel s'enroule le ruban (21).

11. Procédé selon l'une quelconque des revendications précédentes, dans lequel le premier élément de façonnage (23) est cylindrique.

12. Procédé selon l'une quelconque des revendications précédentes, dans lequel le ruban (21) comprend des couches de matériau électroactif.

13. Dispositif pour la fabrication d'un dispositif en céramique à partir d'un ruban dans un état cru, le dispositif comprenant :
un premier élément de façonnage (23) ;
un premier système de serrage (241) pour fixer une extrémité (211) dudit ruban (21) par rapport audit premier élément de façonnage (23) ;
un premier mécanisme (20, 231) pour déplacer ledit ruban (21) et le premier élément de façonnage (23) l'un par rapport à l'autre dans un mouvement comprenant des mouvements de rotation et de translation simultanés, pour enrouler de ce fait ledit ruban (21) autour dudit premier élément de façonnage afin de former un ruban préformé (21), le premier mécanisme étant en outre adapté pour séparer le ruban préformé (21) du premier élément de façonnage (23) après libération du premier système de serrage (24) ;
un deuxième élément de façonnage (33) ;
un deuxième système de serrage (351) pour fixer une extrémité (211) dudit ruban préformé (21) par rapport audit deuxième élément de façonnage (33) ; et
un deuxième mécanisme (351, 352) pour déplacer ledit ruban préformé (21) et le deuxième élément de façonnage (33) l'un par rapport à l'autre dans un mouvement comprenant au moins un mouvement de rotation, pour enrouler de ce fait ledit ruban préformé autour dudit deuxième élément de façonnage (33).

14. Dispositif selon la revendication 13, dans lequel le premier système de serrage (241) comprend une surface à ressort (242) qui, en fonctionnement, presse en continu le ruban (21) sur ledit premier élément de façonnage (23) dans une zone où ledit ruban (21) vient en contact avec ledit premier élément de façonnage (23) pendant que le ruban (21) s'enroule autour du premier élément de façonnage (23).

15. Dispositif selon la revendication 14, dans lequel la surface à ressort est associée à un élément de transmission d'effort (243) adapté pour toucher le bord du ruban (21) dans une zone où ledit ruban (21) vient en contact avec ledit premier élément de façonnage pendant que le ruban (21) s'enroule autour du premier élément de façonnage (23) pour empêcher le glissement dudit ruban (21) par rapport audit premier élément de façonnage (23).

16. Dispositif selon l'une quelconque des revendications 13 à 15, comprenant en outre un bord de décrochage (353) établissant un contact avec le premier élément de façonnage (23) pour séparer ledit premier élément de façonnage (23) et le ruban préformé (21).

17. Dispositif selon l'une quelconque des revendications 13 à 16, dans lequel le deuxième mécanisme comprend un troisième système de serrage (352) pour serrer l'autre extrémité du ruban (21), le deuxième mécanisme étant adapté pour faire tourner de façon relative le troisième système de serrage (352) autour dudit deuxième élément de façonnage (33).

18. Dispositif selon la revendication 17, comprenant en outre une ou plusieurs nacelle(s) (41) comportant des cavités (432) adaptées pour supporter le ruban façonné (21) pendant le séchage.

19. Dispositif selon l'une quelconque des revendications 13 à 18, dans lequel les systèmes de serrage (241, 351) sont actionnés de façon pneumatique.

20. Dispositif selon l'une quelconque des revendications 13 à 19, dans lequel le premier élément de façonnage (23) est une tige cylindrique.

21. Dispositif selon l'une quelconque des revendications 13 à 20, dans lequel le premier mécanisme comprend un entraînement rotatif (231) adapté pour faire tourner le premier élément de façonnage (23) et un système de convoyeur (20) adapté pour faire translater le ruban (21) vers le premier élément de façonnage (23).

22. Dispositif selon la revendication 21, dans lequel le premier mécanisme comprend en outre un entraînement linéaire (231) adapté pour faire translater le premier élément de façonnage (23) le long d'un axe autour duquel s'enroule le ruban (21).
